# EUROPÄISCHE PATENTSCHRIFT

(11) **EP 4 113 348 B1**
(45) Veröffentlichungstag und Bekanntmachung des Hinweises auf die Patenterteilung: **31.12.2025**
(21) Anmeldenummer: 22174696.9
(22) Anmeldetag: 20.05.2022
(51) Int. Cl.: G06F 30/20, B60W 50/00

(54) **VERFAHREN ZUM ENTWICKELN VON FAHRZEUGFUNKTIONEN UND KRAFTFAHRZEUG**
METHOD FOR DEVELOPING VEHICLE FUNCTIONS AND MOTOR VEHICLE
PROCÉDÉ DE DÉVELOPPEMENT DES FONCTIONS DE VÉHICULE ET VÉHICULE AUTOMOBILE

(30) Priorität: 16.06.2021 DE 102021206169
(43) Veröffentlichungstag der Anmeldung: 04.01.2023
(73) Patentinhaber: VOLKSWAGEN AG, 38440 Wolfsburg (DE)
(72) Erfinder: Schöning, Volkmar, 30900 Wedemark (DE); Hüsemann, Frank, 38162 Cremlingen (DE)

(56) Entgegenhaltungen:
- US-A1- 2021 116 907
- WISHART JEFFREY ET AL: "Literature Review of Verification and Validation Activities of Automated Driving Systems", SAE INTERNATIONAL JOURNAL OF CONNECTED AND AUTOMATED VEHICLES, vol. 3, no. 4, 31 March 2020 (2020-03-31), pages 267 - 323, XP055844088, ISSN: 2574-075X, DOI: 10.4271/12-03-04-0020

## Beschreibung

Die vorliegende Erfindung betrifft ein Verfahren zum Entwickeln einer Fahrzeugfunktion zur Durchführung mittels einer Hardware eines Kraftfahrzeugs. Ferner betrifft die Erfindung ein Kraftfahrzeug, welches zur Durchführung der kraftfahrzeugseitigen Verfahrensschritte des Verfahrens ausgebildet ist.

Es ist bekannt, dass künstliche Intelligenz (Kl) zunehmend in vielen Bereichen der Technik eingesetzt wird. Auch in der Automobilindustrie gewinnt KI fortwährend an Bedeutung. Dabei wird KI sowohl im Rahmen der Produktentwicklung als auch der Fertigung sowie im fertigen Produkt eingesetzt.

KI wird in Fachkreisen auch als "artifizielle Intelligenz", "artificial intelligence" oder kurz "AI" bezeichnet und ist ein Teilgebiet der Informatik, welches die Automatisierung von intelligentem Verhalten sowie das maschinelle Lernen betrifft. Als Kl wird beispielsweise die Abbildung von menschlichem Verhalten auf eine Maschine bezeichnet, mit der Zielsetzung, Probleme eigenständig und ohne das Eingreifen eines Menschen zu lösen.

Bei sogenannten autonomen Kraftfahrzeugen übernehmen KI Fahrfunktionen, wie beispielsweise Lenken, Beschleunigen oder Bremsen. Somit ist das Kraftfahrzeug mittels der Kl anhand von Navigationsdaten, Kalendereinträgen oder dergleichen an einen Zielort steuerbar. Zudem können von der KI andere Fahrzeugfunktionen übernommen werden, wie beispielsweise Blinken, Beleuchten, Scheibenwischen, Belüften, Gurtstraffen oder dergleichen. Ein autonomes Kraftfahrzeug ist beispielsweise aus der WO 2019 / 241307 A2 bekannt.

Aus der DE 10 2016 009 655 A1 ist ein Verfahren zum Betrieb eines Kraftfahrzeugs mittels Kl bekannt. Das Kraftfahrzeug weist ein statisches neuronales Netzwerk und ein lernfähiges neuronales Netzwerk auf, welche im Auslieferungszustand des Kraftfahrzeugs einander entsprechen. Im Betrieb des Kraftfahrzeugs werden Entscheidungen beider neuronaler Netze miteinander verglichen. In Abhängigkeit vordefinierter beschränkender Kriterien, wie beispielsweise Sicherheits- oder Ethikkriterien wird dann die für besser befundene Entscheidung verwendet. Die Berücksichtigung ethischer Vorgaben beim Betreiben eines technischen Systems, wie beispielsweise einer Schneidvorrichtung, ist in der IN 2018 110 25 275 A beschrieben. Das Dokument US 2021/116907 A1 offenbart ein Verfahren zum Planen einer Route eines autonomen Kraftfahrzeugs.

Bekannte Systeme zum Betreiben von Kraftfahrzeugen unter Verwendung von KI haben den Nachteil, dass Entscheidungen über eine Modifizierung von Fahrzeugfunktionen eigenständig und lediglich unter Berücksichtigung vordefinierter Regeln bzw. Grenzen treffbar sind. Eine derart hohe Eigenständigkeit der KI kann im Extremfall zu unvorhergesehenen Wechselwirkungen zwischen Komponenten des Kraftfahrzeugs und hierdurch bedingte Störungen führen. Überdies kann insbesondere bei zu weit gesteckten Grenzen ein unkontrollierter Eingriff der KI in das Fahrverhalten des Kraftfahrzeugs zu homologationsrelevanten Veränderungen am Kraftfahrzeug führen, sodass das Kraftfahrzeug seine Zulassung verlieren kann. Zu eng gesteckte Grenzen führen zumeist dazu, dass die KI ihr Potenzial nicht ausnutzen kann und nur kleine, zumeist kaum spürbare Veränderungen von Fahrzeugfunktionen bewirkbar sind. Überdies lassen bekannte Systeme den Betreiber sowie die Entwickler des Kraftfahrzeugs über die Art der durchgeführten Eingriffe im Unklaren. Somit sind etwaige Fehlentwicklungen eines selbstlernenden Systems oftmals nur mit erheblicher Verzögerung identifizierbar.

Es ist daher Aufgabe der vorliegenden Erfindung, die voranstehend beschriebenen Nachteile bei einem Kraftfahrzeug zu beheben oder zumindest teilweise zu beheben. Insbesondere ist es Aufgabe der vorliegenden Erfindung ein Verfahren zum Entwickeln einer Fahrzeugfunktion zur Durchführung mittels einer Hardware eines Kraftfahrzeugs sowie ein Kraftfahrzeug schaffen, die auf eine einfache und kostengünstige Art und Weise das Risiko der Umsetzung fehlerbehafteter Fahrzeugfunktionen reduzieren und/oder eine Entwicklung von Fahrzeugfunktionen erleichtern.

Voranstehende Aufgabe wird durch die Patentansprüche gelöst. Demnach wird die Aufgabe durch ein Verfahren zum Entwickeln einer Fahrzeugfunktion zur Durchführung mittels einer Hardware eines Kraftfahrzeugs mit den Merkmalen des unabhängigen Anspruchs 1 sowie durch ein Kraftfahrzeug mit den Merkmalen des nebengeordneten Anspruchs 10 gelöst. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit dem erfindungsgemäßen Kraftfahrzeug und jeweils umgekehrt, sodass bezüglich der Offenbarung zu den einzelnen Erfindungsaspekten stets wechselseitig Bezug genommen wird beziehungsweise werden kann.

Gemäß einem ersten Aspekt der Erfindung wird die Aufgabe durch ein Verfahren zum Entwickeln einer Fahrzeugfunktion zur Durchführung mittels einer Hardware eines Kraftfahrzeugs gelöst. Unter dem Entwickeln einer Fahrzeugfunktion wird eine Neuschaffung oder eine Verbesserung einer bereits bestehenden Fahrzeugfunktion verstanden, wobei die Fahrzeugfunktion die gezielte Ausleuchtung eines vor einer Frontseite des Kraftfahrzeugs angeordneten Bereichs mittels einer Beleuchtungsvorrichtung ist. Das Verfahren weist die folgenden Verfahrensschritte auf:
- Identifizieren einer zu entwickelnden Fahrzeugfunktion mittels einer Entwicklungsvorrichtung des Kraftfahrzeugs, wobei die Entwicklungsvorrichtung eine künstliche Intelligenz aufweist,
- Erstellen eines Entwurfs der Fahrzeugfunktion mittels der Entwicklungsvorrichtung,
- Durchführen einer ersten Zulässigkeitsprüfung des Entwurfs der Fahrzeugfunktion in Abhängigkeit vordefinierter erster Zulässigkeitskriterien mittels der Entwicklungsvorrichtung,
- Freigabe des Entwurfs der Fahrzeugfunktion zur Übermittlung mittels der Entwicklungsvorrichtung, wenn die ersten Zulässigkeitskriterien erfüllt sind,
- Übermitteln des Entwurfs der Fahrzeugfunktion an eine vom Kraftfahrzeug entfernte Prüfvorrichtung mittels einer ersten Datenübermittlungsvorrichtung des Kraftfahrzeugs,
- Durchführen einer zweiten Zulässigkeitsprüfung des Entwurfs der Fahrzeugfunktion in Abhängigkeit vordefinierter zweiter Zulässigkeitskriterien mittels der Prüfvorrichtung,
- Freigabe des Entwurfs der Fahrzeugfunktion zur Übermittlung mittels der Prüfvorrichtung, wenn die zweiten Zulässigkeitskriterien erfüllt sind,
- Übermitteln des freigegebenen Entwurfs der Fahrzeugfunktion an das Kraftfahrzeug mittels einer zweiten Datenübermittlungsvorrichtung, und
- Implementieren der Fahrzeugfunktion in das Kraftfahrzeug mittels der Entwicklungsvorrichtung.

Die Entwicklungsvorrichtung des Kraftfahrzeugs identifiziert mittels ihrer künstlichen Intelligenz die zu entwickelnde Fahrzeugfunktion des Kraftfahrzeugs. Hierfür wird vorzugsweise in einem Analyseverfahren eine Betriebssituation des Kraftfahrzeugs analysiert. Zur Erfassung der Betriebssituation werden vorzugsweise Sensordaten von Sensoren des Kraftfahrzeugs ausgewertet. Als Ergebnis der Analyse werden vorzugsweise eine oder mehrere zu entwickelnde Fahrzeugfunktionen identifiziert. Unter dem Entwickeln von Fahrzeugfunktionen werden im Rahmen der Erfindung eine Neuschaffung sowie eine Verbesserung bereits bestehender Fahrzeugfunktionen verstanden.

Eine Fahrzeugfunktion ist eine technische Funktion, welche mittels der Hardware des Kraftfahrzeugs realisierbar ist, nämlich die gezielte Ausleuchtung eines vor einer Frontseite des Kraftfahrzeugs angeordneten Bereichs mittels einer Beleuchtungsvorrichtung des Kraftfahrzeugs. Hierbei kann eine Vielzahl unterschiedlicher Beleuchtungsaspekte in Betracht kommen, wie beispielsweise ein Ausleuchten einer Kurve, Vermeiden des Blendens anderer Verkehrsteilnehmer, Vermeiden von Reflektionen, beispielweise durch Pfützen, Nebel oder Niederschlag, Hervorheben besonderer Hinweise oder Gefahren durch gezieltes Anstrahlen oder dergleichen. So kann erfindungsgemäß die Entwicklungsvorrichtung beispielsweise feststellen, dass der Fahrer ein Tempolimit häufig nicht einhält und hieraus die Fahrzeugfunktion des Hervorhebens entsprechender Verkehrsschilder mittels der Beleuchtungsvorrichtung identifizieren. Ebenso kann die Entwicklungsvorrichtung den Vorteil des Ausleuchtens einer Kurve mittels einer zusätzlichen Leuchtvorrichtung, wie beispielsweise einem Nebelscheinwerfer, Fernlicht, Laser oder dergleichen, identifizieren. Dabei kann das Entwickeln der Fahrzeugfunktion auch beinhalten, dass die zu verwendende Hardware des Kraftfahrzeugs auf eine neue Art und Weise verwendet werden soll, wie beispielsweise selektives Ansteuern nur eines Nebellichtscheinwerfers oder eines Teils des Nebellichtscheinwerfers. Dabei ist es zunächst unerheblich, ob die entsprechende Hardware für einen solchen Anwendungsfall vorgesehen bzw. konfiguriert ist.

Die Entwicklungsvorrichtung erstellt anschließend den Entwurf der Fahrzeugfunktion. Der Entwurf der Fahrzeugfunktion weist vorzugsweise sämtliche für die Durchführung der Fahrzeugfunktion relevanten Betriebsparameter des Kraftfahrzeugs auf. Vorzugsweise simuliert die Entwicklungsvorrichtung den Betrieb der Hardware zum Realisieren der Fahrzeugfunktion.

Ferner führt die Entwicklungsvorrichtung die erste Zulässigkeitsprüfung des Entwurfs der Fahrzeugfunktion in Abhängigkeit der vordefinierten ersten Zulässigkeitskriterien durch. Hierfür weist die Entwicklungsvorrichtung die künstliche Intelligenz auf. Die ersten Zulässigkeitskriterien können beispielsweise Gesetze, gewerbliche Schutzrechte, wie beispielsweise Patente, Regelungen, wie beispielsweise Herstellervorgaben oder Entwicklungsrichtlinien, Vorschriften, wie beispielsweise behördliche Zulassungsvorschriften, Funktionssicherheitsanforderungen, dokumentationspflichtige Aspekte, homologationsrelevante Regelungen, ethische Grundsätze oder dergleichen betreffen.

Wenn die Entwicklungsvorrichtung im Rahmen der ersten Zulässigkeitsprüfung zu dem Ergebnis kommt, dass der Entwurf der Fahrzeugfunktion den ersten Zulässigkeitskriterien gerecht wird, gibt diese den Entwurf frei. Mittels der ersten Datenübermittlungsvorrichtung wird der Entwurf der Fahrzeugfunktion an die vom Kraftfahrzeug entfernte Prüfvorrichtung weitergeleitet. In diesem Rahmen wird vorzugsweise eine derartige Dokumentation der Fahrzeugfunktion übermittelt, aus welcher die Fahrzeugfunktion, insbesondere in Abhängigkeit einer definierten Fahrsituation des Kraftfahrzeugs, eindeutig reproduzierbar ist. Der Entwurf der Fahrzeugfunktion wird vorzugsweise von der zweiten Datenübermittlungsvorrichtung empfangen und von dieser der Prüfvorrichtung bereitgestellt. Die Prüfvorrichtung kann beispielsweise in einem Entwicklungszentrum oder Servicezentrum des Kraftfahrzeugherstellers oder einer Werkstatt bereitgestellt werden.

Die Prüfvorrichtung empfängt den Entwurf der Fahrzeugfunktion und führt in Abhängigkeit der vordefinierten zweiten Zulässigkeitskriterien die zweite Zulässigkeitsprüfung durch. Hierbei ist es bevorzugt, dass die Prüfvorrichtung eine künstliche Intelligenz aufweist. Die zweiten Zulässigkeitskriterien können beispielsweise Gesetze, gewerbliche Schutzrechte, wie beispielsweise Patente, Regelungen, wie beispielsweise Herstellervorgaben oder Entwicklungsrichtlinien, Vorschriften, wie beispielsweise behördliche Zulassungsvorschriften, Funktionssicherheitsanforderungen, dokumentationspflichtige Aspekte, homologationsrelevante Regelungen, ethische Grundsätze oder dergleichen betreffen.

Wenn die Prüfvorrichtung im Rahmen der zweiten Zulässigkeitsprüfung zu dem Ergebnis kommt, dass der Entwurf der Fahrzeugfunktion den zweiten Zulässigkeitskriterien gerecht wird, gibt diese den Entwurf frei. Mittels der zweiten Datenübermittlungsvorrichtung wird der freigegebene Entwurf der Fahrzeugfunktion an das Kraftfahrzeug weitergeleitet.

Das Kraftfahrzeug, vorzugsweise die erste Datenübermittlungsvorrichtung, empfängt den freigegebenen Entwurf der Fahrzeugfunktion und leitet ihn vorzugsweise an die Entwicklungsvorrichtung weiter. Die Entwicklungsvorrichtung implementiert die Fahrzeugfunktion in das Kraftfahrzeug, sodass die Fahrzeugfunktion für den Betrieb des Kraftfahrzeugs zur Verfügung steht und ausführbar ist.

Ein erfindungsgemäßes Verfahren zum Entwickeln einer Fahrzeugfunktion zur Durchführung mittels einer Hardware eines Kraftfahrzeugs hat gegenüber herkömmlichen Verfahren zum Betreiben von Kraftfahrzeugen den Vorteil, dass mit einfachen Mitteln sowie auf eine kostengünstige Art und Weise eine Fahrzeugfunktion entwickelbar ist, welche besonders hohen Anforderungen an Betriebssicherheit gerecht wird und ein Haftungsrisiko des Entwicklers bzw. Herstellers des Kraftfahrzeugs reduziert. Während herkömmliche Verfahren zum Betreiben von Kraftfahrzeugen mittels künstlicher Intelligenz lediglich den Bereich "Systementwurf" des "V-Modells" nach VDI 2206 abdecken, sind mittels des erfindungsgemäßen Verfahrens sowohl der "Systementwurf" als auch die "Systemintegration" des "V-Modells" durchführbar und somit Produktverbesserungen erzielbar, welche den Anforderungen einer ganzheitlichen Produktentwicklung gerecht werden.

Gemäß einer bevorzugten Weiterentwicklung der Erfindung kann bei einem Verfahren vorgesehen sein, dass eine Prüfvorrichtung mit einer künstlichen Intelligenz verwendet wird, welche sich von der künstlichen Intelligenz der Entwicklungsvorrichtung unterscheidet. Die künstlichen Intelligenzen weisen vorzugsweise unterschiedliche Algorithmen auf, sodass ein Lösungsweg bei gleicher Problemstellung unterschiedlich verläuft. Dies hat den Vorteil, dass mit einfachen Mitteln sowie auf eine kostengünstige Art und Weise verschiedene Mittel bereitgestellt sind, um von einer Ausgangslage zu einem Ergebnis zu kommen. Somit ist mittels der zweiten Zulässigkeitsprüfung eine verbesserte Verifizierung des Ergebnisses der ersten Zulässigkeitsprüfung durchführbar.

Es ist erfindungsgemäß bevorzugt, dass im Rahmen der zweiten Zulässigkeitsprüfung zweite Zulässigkeitskriterien verwendet werden, welche den ersten Zulässigkeitskriterien vollständig entsprechen, überwiegend entsprechen oder zumindest teilweise entsprechen. Vorzugsweise werden bei beiden Zulässigkeitsprüfungen dieselben Zulässigkeitskriterien verwendet. Dies ist insbesondere dann von Vorteil, wenn die Ermittlungsvorrichtung und Prüfvorrichtung unterschiedliche künstliche Intelligenzen aufweisen. Dies hat den Vorteil, dass mit einfachen Mitteln sowie auf eine kostengünstige Art und Weise eine verbesserte Validierung der Ergebnisse der ersten Zulässigkeitsprüfung mittels der zweiten Zulässigkeitsprüfung gewährleistet ist.

Gemäß einer bevorzugten alternativen Ausführungsform des erfindungsgemäßen Verfahrens werden im Rahmen der zweiten Zulässigkeitsprüfung zweite Zulässigkeitskriterien verwendet, welche von den ersten Zulässigkeitskriterien verschieden sind. Unter verschiedenen Zulässigkeitskriterien werden im Rahmen der Erfindung beispielsweise verschiedene Parameter und/oder verschiedene Ausprägungen gleicher Parameter verstanden. Hierbei ist es bevorzugt, dass die zweiten Zulässigkeitskriterien strenger als die ersten Zulässigkeitskriterien sind. Vorzugsweise sind die zweiten Zulässigkeitskriterien umfangreicher als die ersten Zulässigkeitskriterien. Dies hat den Vorteil, dass mit einfachen Mitteln sowie auf eine kostengünstige Art und Weise das Risiko der Implementierung einer konfliktverursachenden Fahrzeugfunktion reduziert ist.

In einer besonders bevorzugten Ausgestaltung des Verfahrens wird in dem Fall, in dem die zweite Zulässigkeitsprüfung ergibt, dass die zweiten Zulässigkeitskriterien nicht erfüllt sind, der Entwurf der Fahrzeugfunktion in Abhängigkeit der vordefinierten zweiten Zulässigkeitskriterien mittels der Prüfvorrichtung derart modifiziert, dass der modifizierte Entwurf der Fahrzeugfunktion die zweiten Zulassungskriterien erfüllt. Hierfür ist die Prüfvorrichtung ausgebildet und eingerichtet, den Entwurf der Fahrzeugfunktion zu modifizieren und vorzugsweise eine Implementierung in das Kraftfahrzeug im Rahmen einer Simulation zu überprüfen. Die modifizierte Fahrzeugfunktion wird vorzugsweise nur dann zur Implementierung zur Entwicklungsvorrichtung gesendet, wenn die modifizierte Fahrzeugfunktion einer Problemstellung, auf welcher die Identifikation der zu entwickelnden Fahrzeugfunktion erfolgt ist, gerecht wird bzw. das der Problemstellung zugrundeliegende Problem auch wirklich löst. Dies hat den Vorteil, dass mit einfachen Mitteln sowie auf eine kostengünstige Art und Weise eine ständige Verbesserung bzw. Erweiterung der Fahrzeugfunktionen gewährleistet ist. Auch Fahrzeugfunktionen, welche zunächst als unzulässig befunden wurden, werden nicht mehr automatisch verworfen, sondern können bei Erfüllung bestimmter Voraussetzungen zumindest in modifizierter Form implementiert werden.

Vorzugsweise erteilt die Prüfvorrichtung beim Durchführen der zweiten Zulässigkeitsprüfung eine Freigabe erst nach Bestätigung durch eine Kontrollperson. Hierbei ist es erfindungsgemäß bevorzugt, dass eine Vorlage zur Bestätigung nur in dem Fall erfolgt, in dem die Prüfvorrichtung die zweiten Zulässigkeitskriterien bei dem Entwurf der Fahrzeugfunktion als erfüllt feststellt. Weiter bevorzugt stellt die Prüfvorrichtung der Kontrollperson eine Dokumentation des Entwurfs der Fahrzeugfunktion bereit. Es ist bevorzugt, dass die Prüfvorrichtung eine vorläufige Bewertung des Entwurfs der Fahrzeugfunktion der Kontrollperson bereitstellt. Eine derartige Bewertung weist vorzugsweise eine qualitative und/oder quantitative Aussage zum Verhältnis des Entwurfs der Fahrzeugfunktion zu den ersten Zulassungskriterien und/oder den zweiten Zulassungskriterien auf. Die endgültige Freigabe des Entwurfs der Fahrzeugfunktion wird erfindungsgemäß vorzugsweise durch die Kontrollperson erteilt. Unter einer Kontrollperson wird im Rahmen der Erfindung eine natürliche Person, wie beispielsweise ein Entwicklungsingenieur des Kraftfahrzeugherstellers oder ein Prüfbeamter einer Zulassungsbehörde, oder eine juristische Person, wie beispielsweise der Kraftfahrzeughersteller oder die Zulassungsbehörde verstanden, wobei eine juristische Person auch durch eine künstliche Intelligenz vertreten sein kann. Vorzugsweise erfolgt eine Freigabe erst nach Bestätigung durch einen Vertreter des Kraftfahrzeugherstellers und einen Vertreter der Zulassungsbehörde. Dies hat den Vorteil, dass mit einfachen Mitteln sowie auf eine kostengünstige Art und Weise ein Haftungsrisiko im Falle einer Fehlfunktion des Kraftfahrzeugs im Zusammenhang mit der entwickelten Fahrzeugfunktion reduziert ist.

Gemäß einer bevorzugten Ausführungsform der Erfindung kann bei einem Verfahren vorgesehen sein, dass die Entwicklungsvorrichtung und/oder die Prüfvorrichtung eine Hardwareanalyse der Hardware des Kraftfahrzeugs in Abhängigkeit des Entwurfs der Fahrzeugfunktion durchführt und hieraus eine Modifizierung der Hardware zur verbesserten Umsetzung der Fahrzeugfunktion entwickelt. Im Rahmen der Hardwareanalyse wird vorzugsweise ermittelt, wie gut die Fahrzeugfunktion mittels der vorhandenen Hardware ausführbar ist und ob eine etwaige Modifizierung der Hardware die Ausführung der Fahrzeugfunktion verbessern kann. Hierbei werden vorzugsweise weitere Aspekte, wie beispielsweise Herstellungskosten, Teilevariantenzahl, zusätzlicher Nutzen, Montageaufwand, Betriebssicherheit, Lebensdauer, Komplexität oder dergleichen, berücksichtigt, um eine ganzheitliche Verbesserung für den Kraftfahrzeughersteller zu erzielen. Bei einer Fahrzeugfunktion, welche eine zusätzliche Ausleuchtung einer Kurve mittels eines Fernlichtscheinwerfers kann die Hardwareanalyse beispielsweise ergeben, dass die Steuerung der Fernlichtscheinwerfer derart modifiziert werden muss, dass eine selektive Ansteuerung des linken und des rechten Fernlichtscheinwerfers realisierbar ist. Ebenso kann die Hardwareanalyse ergeben, dass nur eine partielle Ansteuerung eines Fernlichtscheinwerfers, beispielsweise bei einem LED-Scheinwerfer, nur ein bestimmter Teil der LEDs mittels der Steuerung möglich ist. Eventuell bedarf dies einer Hardwaremodifikation der Fernlichtscheinwerfer. Dies hat den Vorteil, dass mit einfachen Mitteln sowie auf eine kostengünstige Art und Weise die Entwicklung des Kraftfahrzeugs verbessert ist.

Besonders bevorzugt erfolgt das Übermitteln des freigegebenen Entwurfs der Fahrzeugfunktion mittels der zweiten Datenübermittlungsvorrichtung an mehrere Kraftfahrzeuge. Die Kraftfahrzeuge weisen vorzugsweise die gleiche Hardware oder zumindest vergleichbare Hardware auf. Hierbei ist insbesondere die Hardware gemeint, welche für die Ausführung der Fahrzeugfunktion erforderlich ist. Die Fahrzeuge können beispielsweise dieselbe Typenbezeichnung aufweisen. Dies hat den Vorteil, dass mit einfachen Mitteln sowie auf eine kostengünstige Art und Weise die Entwicklung von Fahrzeugfunktionen verbessert ist. Es reicht aus, dass mittels eines Kraftfahrzeugs eine neue Fahrzeugfunktion erstellt wird, welche anschließend von einer Vielzahl von Kraftfahrzeugen implementierbar ist. Somit können auch jene Kraftfahrzeuge diese Fahrzeugfunktion implementieren, welche die Fahrzeugfunktion noch nicht identifiziert haben. Überdies reicht es aus, wenn nur ein Teil der Kraftfahrzeuge eines Fahrzeugtyps eine Entwicklungsvorrichtung und ggf. hierfür zusätzliche Sensoren aufweist, sodass Herstellungskosten bei den übrigen Kraftfahrzeugen, welche keine Entwicklungsvorrichtung und/oder weniger Sensoren aufweisen, einsparbar sind.

Es ist erfindungsgemäß bevorzugt, dass das Identifizieren der zu entwickelnden Fahrzeugfunktion unter Berücksichtigung von Betriebsparametern des Kraftfahrzeugs und/oder Umgebungsparametern einer Umgebung des Kraftfahrzeugs und/oder Umweltparameter im Umfeld des Kraftfahrzeugs erfolgt. Betriebsparameter des Kraftfahrzeugs sind beispielsweise: Motor-/Raddrehzahl, Geschwindigkeit, Beschleunigung, Verzögerung, Gierrate, Rollrate, Nickrate, Lenkwinkel, Reifenluftdruck, Kühlwassertemperatur, Abblendwinkel oder dergleichen. Umgebungsparameter sind beispielsweise Fahrbahnbeschaffenheit, Fahrbahnrichtung, Steigung, Gefälle, Hindernisse, andere Verkehrsteilnehmer oder dergleichen. Umweltparameter sind beispielsweise Temperatur, Luftfeuchtigkeit, Bewölkung, Nebel, Sonnenstand, Umgebungsluftdruck, Niederschlagsintensität, Niederschlagsart, liegengebliebener Niederschlag, Windrichtung, Windstärke oder dergleichen. Dies hat den Vorteil, dass mit einfachen Mitteln sowie auf eine kostengünstige Art und Weise Fahrzeugfunktionen entwickelbar sind, welche auf einen Betrieb des Kraftfahrzeugs besonders abgestimmt sind.

Gemäß einem zweiten Aspekt der Erfindung wird die Aufgabe durch ein Kraftfahrzeug gelöst. Das Kraftfahrzeug weist eine Entwicklungsvorrichtung mit einer künstlichen Intelligenz zum Entwickeln einer Fahrzeugfunktion des Kraftfahrzeugs und eine erste Datenübermittlungsvorrichtung zum Übermitteln von Daten an eine externe Empfangseinheit auf. Erfindungsgemäß ist das Kraftfahrzeug ausgebildet, die kraftfahrzeugseitigen Verfahrensschritte eines erfindungsgemäßen Verfahrens durchzuführen.

Unter den kraftfahrzeugseitigen Verfahrensschritten werden die Verfahrensschritte verstanden, welche mittels der Hardware des Kraftfahrzeugs, wie beispielsweise der Entwicklungsvorrichtung und der ersten Datenübermittlungsvorrichtung, ausgeführt werden. Demnach ist das Kraftfahrzeug erfindungsgemäß ausgebildet, zumindest die folgenden Verfahrensschritte auszuführen:
- Identifizieren der zu entwickelnden Fahrzeugfunktion mittels der Entwicklungsvorrichtung,
- Erstellen des Entwurfs der Fahrzeugfunktion mittels der Entwicklungsvorrichtung,
- Durchführen der ersten Zulässigkeitsprüfung des Entwurfs der Fahrzeugfunktion in Abhängigkeit vordefinierter erster Zulässigkeitskriterien mittels der Entwicklungsvorrichtung,
- Freigabe des Entwurfs der Fahrzeugfunktion zur Übermittlung mittels der Entwicklungsvorrichtung, wenn die Zulässigkeitskriterien erfüllt sind,
- Übermitteln des Entwurfs der Fahrzeugfunktion an die Prüfvorrichtung mittels der ersten Datenübermittlungsvorrichtung, und
- Implementieren der Fahrzeugfunktion in das Kraftfahrzeug mittels der Entwicklungsvorrichtung.
Zudem ist das Kraftfahrzeug ausgebildet, den freigegebenen Entwurf der Fahrzeugfunktion von der zweiten Datenübermittlungsvorrichtung zu empfangen, vorzugsweise mittels der ersten Datenübermittlungsvorrichtung. Die externe Empfangseinheit kann beispielsweise als eine zweite Datenübermittlungsvorrichtung ausgebildet und datenkommunizierend mit einer Prüfvorrichtung gekoppelt sein.

Bei dem erfindungsgemäßen Kraftfahrzeug ergeben sich sämtliche Vorteile, die bereits zu einem Verfahren gemäß dem ersten Aspekt der Erfindung beschrieben worden sind. Demnach hat das erfindungsgemäße Kraftfahrzeug gegenüber herkömmlichen Kraftfahrzeugen den Vorteil, dass mit einfachen Mitteln sowie auf eine kostengünstige Art und Weise eine Fahrzeugfunktion entwickelbar ist, welche besonders hohen Anforderungen an Betriebssicherheit gerecht wird und ein Haftungsrisiko des Entwicklers bzw. Herstellers des Kraftfahrzeugs reduziert. Während bei herkömmlichen Kraftfahrzeugen mittels künstlicher Intelligenz lediglich der Bereich "Systementwurf" des "V-Modells" nach VDI 2206 abdeckbar ist, sind mittels des erfindungsgemäßen Kraftfahrzeugs sowohl der "Systementwurf" als auch die "Systemintegration" des "V-Modells" durchführbar und somit Produktverbesserungen erzielbar, welche den Anforderungen einer ganzheitlichen Produktentwicklung gerecht werden.

Ein erfindungsgemäßes Verfahren zum Entwickeln einer Fahrzeugfunktion zur Durchführung mittels einer Hardware eines Kraftfahrzeugs sowie ein erfindungsgemäßes Kraftfahrzeug werden nachfolgend anhand von Zeichnungen näher erläutert. Es zeigen jeweils schematisch:
- Figur 1: ein V-Modell nach VDI 2208,
- Figur 2: in einem Ablaufdiagramm eine bevorzugte Ausführungsform des erfindungsgemäßen Verfahrens, und
- Figur 3: in einer Seitenansicht eine bevorzugte Ausführungsform eines erfindungsgemäßen Kraftfahrzeugs.

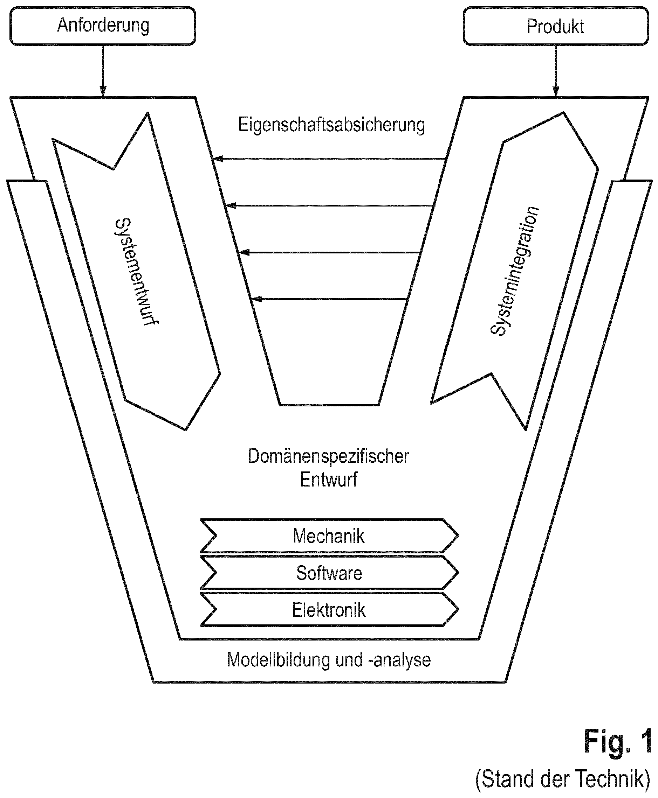

Elemente mit gleicher Funktion und Wirkungsweise sind in den Figuren 1 bis 3 jeweils mit denselben Bezugszeichen versehen.

In Fig. 1 ist ein V-Modell nach VDI 2208 schematisch abgebildet. Ausgehend von einer Anforderung, welche der Identifizierung der Fahrzeugfunktion entspricht, wird ein Systementwurf erstellt, welcher in einem iterativen Verfahren im Rahmen einer Systemintegration zum Produkt, wie beispielsweise der implementierten Fahrzeugfunktion, transformiert wird.

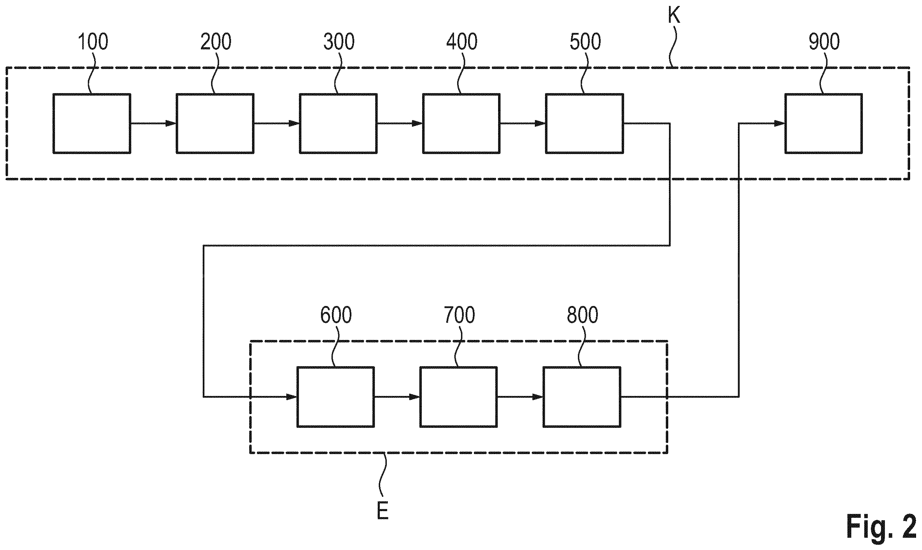

Fig. 2 zeigt eine bevorzugte Ausführungsform des erfindungsgemäßen Verfahrens schematisch in einem Ablaufdiagramm. In einem ersten Verfahrensschritt 100 wird eine zu entwickelnde Fahrzeugfunktion mittels einer künstlichen Intelligenz einer Entwicklungsvorrichtung 3 eines Kraftfahrzeugs 2 identifiziert. Dies erfolgt vorzugsweise während des Betriebs des Kraftfahrzeugs 2. In einem zweiten Verfahrensschritt 200 wird mittels der Entwicklungsvorrichtung 3 ein Entwurf der Fahrzeugfunktion erstellt. In einem dritten Verfahrensschritt 300 führt die Entwicklungsvorrichtung 3 eine erste Zulässigkeitsprüfung des Entwurfs der Fahrzeugfunktion in Abhängigkeit vordefinierter erster Zulässigkeitskriterien durch. In diesem Rahmen kann beispielsweise geprüft werden, ob Gesetze, Regelungen oder Patente verletzt werden. Wenn eine Verletzung der ersten Zulässigkeitskriterien festgestellt wird, erfolgt vorzugsweise in einem zusätzlichen Verfahrensschritt eine Modifizierung des Entwurfs der Fahrzeugfunktion mittels der Entwicklungsvorrichtung 3. Wenn die ersten Zulassungskriterien erfüllt sind, gibt die Entwicklungsvorrichtung 3 den Entwurf der Fahrzeugfunktion in einem vierten Verfahrensschritt 400 frei. In einem fünften Verfahrensschritt 500 wird der Entwurf der Fahrzeugfunktion mittels einer ersten Datenübermittlungsvorrichtung 5 des Kraftfahrzeugs 2 an eine vom Kraftfahrzeug 2 entfernte Prüfvorrichtung 4 weitergeleitet. Der weitergeleitete Entwurf der Fahrzeugfunktion weist vorzugsweise sämtliche Daten auf, welche für eine Homologation erforderlich sind.

In einem sechsten Verfahrensschritt 600 führt die Prüfvorrichtung 4 eine zweite Zulässigkeitsprüfung des Entwurfs der Fahrzeugfunktion in Abhängigkeit vordefinierter zweiter Zulässigkeitskriterien durch. Dies erfolgt vorzugsweise unter Zuhilfenahme einer künstlichen Intelligenz der Prüfvorrichtung 4 und/oder durch eine Kontrollperson. In einem siebten Verfahrensschritt 700 wird der Entwurf der Fahrzeugfunktion mittels der Prüfvorrichtung 4 zur Übermittlung freigegeben, wenn die zweiten Zulässigkeitskriterien erfüllt sind. In einem achten Verfahrensschritt 800 wird der freigegebene Entwurf der Fahrzeugfunktion mittels einer zweiten Datenübermittlungsvorrichtung 6 an das Kraftfahrzeug 2 übermittelt. In einem neunten Verfahrensschritt 900 wird die Fahrzeugfunktion mittels der Entwicklungsvorrichtung 3 in das Kraftfahrzeug 2 implementiert. Die Verfahrensschritte vom ersten Verfahrensschritt 100 bis zum fünften Verfahrensschritt 500 sowie der neunte Verfahrensschritt 900 werden auch als kraftfahrzeugseitige Verfahrensschritte K bezeichnet. Die Verfahrensschritte vom sechsten Verfahrensschritt 600 bis zum achten Verfahrensschritt 800 werden auch als externe Verfahrensschritte E bezeichnet.

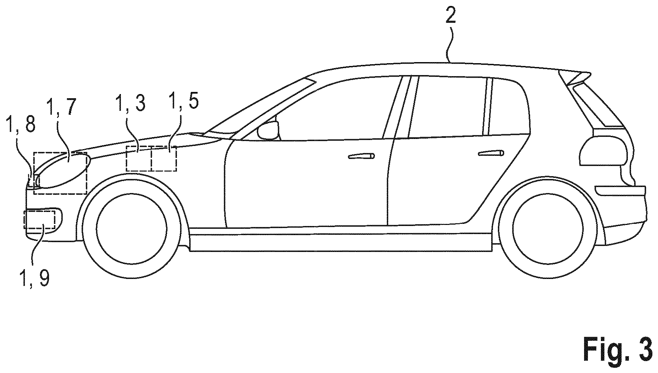

In Fig. 3 ist eine bevorzugte Ausführungsform eines erfindungsgemäßen Kraftfahrzeugs 2 schematisch in einer Seitenansicht dargestellt. Das Kraftfahrzeug 2 weist eine Vielzahl von Hardware 1 auf, wie beispielsweise eine Entwicklungsvorrichtung 3, eine erste Datenübermittlungsvorrichtung 5, eine Abblendfrontleuchte 7 zum Erzeugen eines Abblendlichts in einem vor dem Kraftfahrzeug 2 liegenden Fahrbahnbereich, einen Sensor 8 zum Erfassen einer ortsabhängigen Lichtintensität im Fahrbahnbereich, und eine Nebelfrontleuchte 9 zum verstärkten Ausleuchten eines vor dem Kraftfahrzeug angeordneten Fahrbahnabschnitts.

### Bezugszeichenliste

- 1: Hardware
- 2: Kraftfahrzeug
- 3: Entwicklungsvorrichtung
- 4: Prüfvorrichtung
- 5: erste Datenübermittlungsvorrichtung
- 6: zweite Datenübermittlungsvorrichtung
- 7: Abblendfrontleuchte
- 8: Sensor
- 9: Nebelfrontleuchte

- 100: erster Verfahrensschritt
- 200: zweiter Verfahrensschritt
- 300: dritter Verfahrensschritt
- 400: vierter Verfahrensschritt
- 500: fünfter Verfahrensschritt
- 600: sechster Verfahrensschritt
- 700: siebter Verfahrensschritt
- 800: achter Verfahrensschritt
- 900: neunter Verfahrensschritt

- K: kraftfahrzeugseitige Verfahrensschritte
- E: externe Verfahrensschritte

## Patentansprüche

1. Verfahren zum Entwickeln einer Fahrzeugfunktion zur Durchführung mittels einer Hardware (1) eines Kraftfahrzeugs (2), wobei unter dem Entwickeln einer Fahrzeugfunktion eine Neuschaffung oder eine Verbesserung einer bereits bestehenden Fahrzeugfunktion verstanden wird, wobei die Fahrzeugfunktion die gezielte Ausleuchtung eines vor einer Frontseite des Kraftfahrzeugs (2) angeordneten Bereichs mittels einer Beleuchtungsvorrichtung ist, aufweisend die folgenden Verfahrensschritte:
- Identifizieren der zu entwickelnden Fahrzeugfunktion mittels einer Entwicklungsvorrichtung (3) des Kraftfahrzeugs (2), wobei die Entwicklungsvorrichtung (3) eine künstliche Intelligenz aufweist,
- Erstellen eines Entwurfs der Fahrzeugfunktion mittels der Entwicklungsvorrichtung (3),
- Durchführen einer ersten Zulässigkeitsprüfung des Entwurfs der Fahrzeugfunktion in Abhängigkeit vordefinierter erster Zulässigkeitskriterien mittels der Entwicklungsvorrichtung (3),
- Freigabe des Entwurfs der Fahrzeugfunktion zur Übermittlung mittels der Entwicklungsvorrichtung (3), wenn die ersten Zulässigkeitskriterien erfüllt sind,
- Übermitteln des Entwurfs der Fahrzeugfunktion an eine vom Kraftfahrzeug (2) entfernte Prüfvorrichtung (4) mittels einer ersten Datenübermittlungsvorrichtung (5) des Kraftfahrzeugs (2),
- Durchführen einer zweiten Zulässigkeitsprüfung des Entwurfs der Fahrzeugfunktion in Abhängigkeit vordefinierter zweiter Zulässigkeitskriterien mittels der Prüfvorrichtung (4),
- Freigabe des Entwurfs der Fahrzeugfunktion zur Übermittlung mittels der Prüfvorrichtung (4), wenn die zweiten Zulässigkeitskriterien erfüllt sind,
- Übermitteln des freigegebenen Entwurfs der Fahrzeugfunktion an das Kraftfahrzeug (2) mittels einer zweiten Datenübermittlungsvorrichtung (6), und
- Implementieren der Fahrzeugfunktion in das Kraftfahrzeug (2) mittels der Entwicklungsvorrichtung (3).

2. Verfahren nach Anspruch 1,
**dadurch gekennzeichnet,**
**dass** eine Prüfvorrichtung (4) mit einer künstlichen Intelligenz verwendet wird, welche sich von der künstlichen Intelligenz der Entwicklungsvorrichtung (3) unterscheidet.

3. Verfahren nach Anspruch 1 oder 2,
**dadurch gekennzeichnet,**
**dass** im Rahmen der zweiten Zulässigkeitsprüfung zweite Zulässigkeitskriterien verwendet werden, welche den ersten Zulässigkeitskriterien vollständig entsprechen, überwiegend entsprechen oder zumindest teilweise entsprechen.

4. Verfahren nach Anspruch 1 oder 2,
**dadurch gekennzeichnet,**
**dass** im Rahmen der zweiten Zulässigkeitsprüfung zweite Zulässigkeitskriterien verwendet werden, welche von den ersten Zulässigkeitskriterien verschieden sind.

5. Verfahren nach wenigstens einem der vorangegangenen Ansprüche,
**dadurch gekennzeichnet,**
**dass** in dem Fall, in dem die zweite Zulässigkeitsprüfung ergibt, dass die zweiten Zulässigkeitskriterien nicht erfüllt sind, der Entwurf der Fahrzeugfunktion in Abhängigkeit der vordefinierten zweiten Zulässigkeitskriterien mittels der Prüfvorrichtung (4) derart modifiziert wird, dass der modifizierte Entwurf der Fahrzeugfunktion die zweiten Zulassungskriterien erfüllt.

6. Verfahren nach wenigstens einem der vorangegangenen Ansprüche,
**dadurch gekennzeichnet,**
**dass** die Prüfvorrichtung (4) beim Durchführen der zweiten Zulässigkeitsprüfung eine Freigabe erst nach Bestätigung durch eine Kontrollperson erteilt.

7. Verfahren nach wenigstens einem der vorangegangenen Ansprüche,
**dadurch gekennzeichnet,**
**dass** die Entwicklungsvorrichtung (3) und/oder die Prüfvorrichtung (4) eine Hardwareanalyse der Hardware (1) des Kraftfahrzeugs (2) in Abhängigkeit des Entwurfs der Fahrzeugfunktion durchführt und hieraus eine Modifizierung der Hardware (1) zur verbesserten Umsetzung der Fahrzeugfunktion entwickelt.

8. Verfahren nach wenigstens einem der vorangegangenen Ansprüche,
**dadurch gekennzeichnet,**
**dass** das Übermitteln des freigegebenen Entwurfs der Fahrzeugfunktion mittels der zweiten Datenübermittlungsvorrichtung (6) an mehrere Kraftfahrzeuge (2) erfolgt.

9. Verfahren nach wenigstens einem der vorangegangenen Ansprüche,
**dadurch gekennzeichnet,**
**dass** das Identifizieren der zu entwickelnden Fahrzeugfunktion unter Berücksichtigung von Betriebsparametern des Kraftfahrzeugs (2) und/oder Umgebungsparametern einer Umgebung des Kraftfahrzeugs (2) und/oder Umweltparameter im Umfeld des Kraftfahrzeugs (2) erfolgt.

10. Kraftfahrzeug (2), aufweisend eine Entwicklungsvorrichtung (3) mit einer künstlichen Intelligenz zum Entwickeln einer Fahrzeugfunktion des Kraftfahrzeugs (2) und eine erste Datenübermittlungsvorrichtung (5) zum Übermitteln von Daten an eine externe Empfangseinheit,
**dadurch gekennzeichnet,**
**dass** das Kraftfahrzeug (2) ausgebildet ist, die kraftfahrzeugseitigen Verfahrensschritte eines Verfahrens nach einem der vorangegangenen Ansprüche durchzuführen.

## Claims

1. Method for developing a vehicle function to be carried out by means of a piece of hardware (1) of a motor vehicle (2), wherein developing a vehicle function means creating a new vehicle function or improving an existing vehicle function, wherein the vehicle function is the targeted illumination, by means of a lighting device, of a region arranged in front of a front side of the motor vehicle (2), the method comprising the following method steps:
- identifying, by means of a development device (3) of the motor vehicle (2), the vehicle function to be developed, wherein the development device (3) is equipped with artificial intelligence,
- creating a design of the vehicle function by means of the development device (3),
- carrying out, by means of the development device (3), a first permissibility check on the vehicle function design in accordance with predefined first permissibility criteria,
- by means of the development device (3), approving the vehicle function design for transmission if the initial permissibility criteria are met,
- transmitting the vehicle function design to a checking device (4), which is remote from the motor vehicle (2), by means of a first data transmission device (5) of the motor vehicle (2),
- carrying out a second permissibility check on the vehicle function design in accordance with a predefined second admissibility criteria, by means of the checking device (4),
- by means of the checking device (4), approving the vehicle function design for transmission if the second permissibility criteria are met,
- transmitting the approved vehicle function design to the motor vehicle (2) by means of a second data transmission device (6), and
- implementing the vehicle function in the motor vehicle (2) by means of the development device (3).

2. Method according to claim 1,
**characterized in that,**
a checking device (4) having an artificial intelligence is used, which artificial intelligence differs from the artificial intelligence of the development device (3).

3. Method according to claim 1 or 2,
**characterized in that,**
as part of the second permissibility check, second permissibility criteria are used which fully correspond, largely correspond, or at least partially correspond to the first permissibility criteria.

4. Method according to claim 1 or 2,
**characterized in that,**
as part of the second permissibility check, second permissibility criteria are used which differ from the first permissibility criteria.

5. Method according to at least one of the preceding claims,
**characterized in that,**
in the event that the second permissibility check reveals that the second permissibility criteria are not met, the vehicle function design is modified by means of the checking device (4) in accordance with the predefined second permissibility criteria in such a way that the modified vehicle function design satisfies the second permissibility criteria.

6. Method according to at least one of the preceding claims,
**characterized in that,**
when carrying out the second permissibility check, the checking device (4) only grants approval after confirmation by a control person.

7. Method according to at least one of the preceding claims,
**characterized in that,**
the development device (3) and/or the checking device (4) carries out hardware analysis of the hardware (1) of the motor vehicle (2) in accordance with the vehicle function design and, from this analysis, develops a modification to the hardware (1) for improved implementation of the vehicle function.

8. Method according to at least one of the preceding claims,
**characterized in that,**
the approved vehicle function design is transmitted to a plurality of motor vehicles (2) by means of the second data transmission device (6).

9. Method according to at least one of the preceding claims,
**characterized in that,**
the vehicle function to be developed is identified taking into account operating parameters of the motor vehicle (2) and/or surroundings parameters of surroundings of the motor vehicle (2) and/or ambient parameters in the vicinity of the motor vehicle (2).

10. Motor vehicle (2) comprising a development device (3) having an artificial intelligence for developing a vehicle function of the motor vehicle (2), and comprising a first data transmission device (5) for transmitting data to an external receiving unit,
**characterized in that,**
the motor vehicle (2) is designed to carry out the motor vehicle-side method steps of a method according to any of the preceding claims.

## Revendications

1. Procédé pour le développement d'une fonction de véhicule à réaliser au moyen d'un matériel (1) d'un véhicule automobile (2), dans lequel le développement d'une fonction de véhicule implique une nouvelle création ou une amélioration d'une fonction de véhicule déjà existante, dans lequel la fonction de véhicule est l'éclairage ciblé d'une zone disposée devant un côté avant du véhicule automobile (2) au moyen d'un dispositif d'éclairage, présentant les étapes de procédé suivantes :
- identification de la fonction de véhicule à développer au moyen d'un dispositif de développement (3) du véhicule automobile (2), dans lequel le dispositif de développement (3) présente une intelligence artificielle,
- création d'une conception de la fonction de véhicule au moyen du dispositif de développement (3),
- réalisation d'un premier essai d'admissibilité de la conception de la fonction de véhicule en fonction de premiers critères d'admissibilité prédéfinis au moyen du dispositif de développement (3),
- autorisation de la conception de la fonction de véhicule pour sa transmission au moyen du dispositif de développement (3) lorsque les premiers critères d'admissibilité sont remplis,
- transmission de la conception de la fonction de véhicule à un dispositif d'essai (4) éloigné du véhicule automobile (2) au moyen d'un premier dispositif de transmission de données (5) du véhicule automobile (2),
- réalisation d'un second essai d'admissibilité de la conception de la fonction de véhicule en fonction de seconds critères d'admissibilité prédéfinis au moyen du dispositif d'essai (4),
- autorisation de la conception de la fonction de véhicule pour sa transmission au moyen du dispositif de développement (4) lorsque les seconds critères d'admissibilité sont remplis,
- transmission de la conception autorisée de la fonction de véhicule au véhicule automobile (2) au moyen d'un second dispositif de transmission de données (6), et
- mise en œuvre de la fonction de véhicule dans le véhicule automobile (2) au moyen du dispositif de développement (3).

2. Procédé selon la revendication 1,
**caractérisé en ce que**
un dispositif d'essai (4) est utilisé, lequel comporte une intelligence artificielle différente de l'intelligence artificielle du dispositif de développement (3).

3. Procédé selon la revendication 1 ou 2,
**caractérisé en ce que,**
dans le cadre du second essai d'admissibilité, de seconds critères d'admissibilité sont utilisés, lesquels correspondent entièrement, correspondent principalement ou correspondent au moins partiellement aux premiers critères d'admissibilité.

4. Procédé selon la revendication 1 ou 2,
**caractérisé en ce que,**
dans le cadre du second essai d'admissibilité, de seconds critères d'admissibilité sont utilisés, lesquels sont différents des premiers critères d'admissibilité.

5. Procédé selon au moins l'une des revendications précédentes,
**caractérisé en ce que,**
dans le cas où le second essai d'admissibilité montre que les seconds critères d'admissibilité ne sont pas remplis, la conception de la fonction de véhicule est modifiée en fonction des seconds critères d'admissibilité prédéfinis au moyen du dispositif d'essai (4) de telle sorte que la conception modifiée de la fonction de véhicule remplit les seconds critères d'admissibilité.

6. Procédé selon au moins l'une des revendications précédentes,
**caractérisé en ce que**
le dispositif d'essai (4), lors de la réalisation du second essai d'admissibilité, accorde une autorisation uniquement après confirmation par une personne de contrôle.

7. Procédé selon au moins l'une des revendications précédentes,
**caractérisé en ce que**
le dispositif de développement (3) et/ou le dispositif d'essai (4) réalisent une analyse matérielle du matériel (1) du véhicule automobile (2) en fonction de la conception de la fonction de véhicule et développe à partir de là une modification du matériel (1) pour une mise en pratique améliorée de la fonction de véhicule.

8. Procédé selon au moins l'une des revendications précédentes,
**caractérisé en ce que**
la transmission de la conception autorisée de la fonction de véhicule est effectuée au moyen du second dispositif de transmission de données (6) à plusieurs véhicules automobiles (2).

9. Procédé selon au moins l'une des revendications précédentes,
**caractérisé en ce que**
l'identification de la fonction de véhicule à développer est effectuée en prenant en compte des paramètres de fonctionnement du véhicule automobile (2) et/ou des paramètres d'entourage d'un entourage du véhicule automobile (2) et/ou de paramètres environnementaux dans l'environnement du véhicule automobile (2).

10. Véhicule automobile (2), présentant un dispositif de développement (3) comportant une intelligence artificielle pour le développement d'une fonction de véhicule du véhicule automobile (2) et un premier dispositif de transmission de données (5) pour la transmission de données à une unité de réception externe,
**caractérisé en ce que**
le véhicule automobile (2) est configuré pour réaliser les étapes de procédé côté véhicule automobile d'un procédé selon l'une des revendications précédentes.
